(19) Europäisches Patentamt
European Patent Office
Office européen des brevets

(11) Publication number : 0 496 554 A1

# (12) EUROPEAN PATENT APPLICATION

(21) Application number : 92300458.4

(51) Int. Cl.$^5$ : **G03F 7/16**, C09D 5/44

(22) Date of filing : 20.01.92

(30) Priority : 22.01.91 GB 9101345

(43) Date of publication of application : 29.07.92 Bulletin 92/31

(84) Designated Contracting States : AT BE CH DE FR GB IT LI NL

(71) Applicant : CIBA-GEIGY AG
Klybeckstrasse 141
CH-4002 Basel (CH)

(72) Inventor : Hatton, Kevin Brian
407 Mayflower House
Manhatton Drive, Cambridge (GB)

(74) Representative : Sparrow, Kenneth D. et al
CIBA-GEIGY PLC. Patent Department, Central Research, Hulley Road
Macclesfield, Cheshire SK10 2NX (GB)

## (54) Electrodeposition method.

(57) A method of producing a positive image on a substrate, which method comprises the steps of a) immersing a copper-clad laminate, as a cathode, in an electrolytic bath containing an electrodepositable, non-photosensitive polymer, and electrodepositing a film of the polymer on to the laminate ; b) immersing the laminate, coated with the polymer in step a), as an anode or, preferably, as a cathode, in an electrolytic bath containing a naphthoquinone diazide sulphonamide of formula (I) :

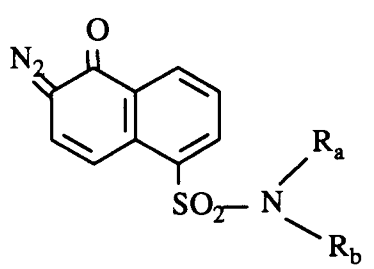

I

in which $R_a$ and $R_b$ independently, are hydrogen, provided that $R_a$ and $R_b$ are not both hydrogen ; $C_1$-$C_8$ alkylene substituted by an optionally substituted amino group ; a phenyl group which is optionally substituted by an amino group ; or $R_a$ and $R_b$ together form a 5- or 6- membered optionally substituted heterocyclic ring which either contains an amino-containing group within the ring, or has an amino-containing group substituted on the ring and electro depositing a film of the sulphonamide on to the polymer-coated laminate ; c) irradiating the dried, coated laminate obtained in step b) through a mask ; and d) developing the irradiated, coated laminate to produce a positive image of the mask.

EP 0 496 554 A1

The present relates to an electrodeposition method, in particular to an electrodeposition method for producing positive images on copper by the use of two electrodeposition baths.

Positive images on copper for use, e.g. as printed circuits, may be produced by various methods.

In the case of single sided printed laminate boards, the board, comprising a copper clad base laminate, has holes drilled where desired. A resist is coated on the copper in a predetermined pattern, using screen printing or photo-imaging techniques, to produce a board which has exposed copper in some areas, and copper coated by the resist in the remaining areas. The exposed copper is then plated with a tin-lead alloy, which is finally removed using a tin-lead alloy stripper.

In the case of double sided, plated through hole printed circuit boards, the procedure is similar but with the following additional steps: after the holes are drilled, the board is subjected to electroless copper deposition to deposit copper on the surface of the holes (as well as over all the copper); and, after applying the resist in a predetermined pattern, the board is subjected to copper electroplating to deposit copper on the exposed copper parts, including the surface of the holes.

Disadvantages of these known processes are the high cost of the tin-lead alloy stripper and the necessary subsequent cleaning. Moreover, the tin-lead stripper, usually a mixture of hydrogen peroxide and sulphuric acid, is aggressive to the boards themselves and to the personnel and equipment used in carrying out the stripping procedure.

In European Patent Specification No: 0315165, there is described a positive-type photosensitive electrodeposition coating composition comprising, as a main component, a water-soluble or water-dispersible resin which contains, in the molecule, modified quinone diazide sulphone units of formula:

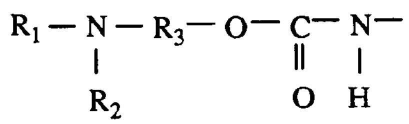

in which $R_1$ represents:

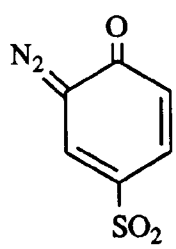

or

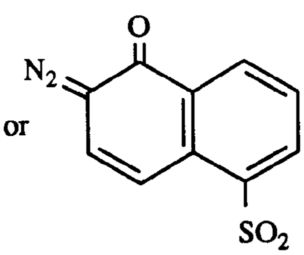

$R_2$ is hydrogen, alkyl, cycloalkyl or an alkyl ether group; and $R_3$ is alkylene, cycloalkylene, or an alkylene ether group.

The use of the resins of EP 0315165, however, has certain disadvantages. The quinone diazide sulphone moieties in the resin are heat-sensitive, and these moieties are liable to thermal decomposition during the manufacture of the resins containing such moieties. Accordingly, the manufacture of the resins used in EP 0315165 can suffer restrictions in terms of reaction temperature and/or reaction time in order to avoid the said thermal composition. Moreover, electrolytic deposition baths containing the resins of EP 0315165 tend to be rather unstable.

In European Patent Specification No: 0335330, a two-bath electrodeposition coating process of a photoresist for printed circuit boards is described. Firstly, a photosensitive coating composition, which may comprise, e.g., a naphthoquinonediazide, is electrodeposited on a conductive surface. Subsequently, there is further electrodeposited, on to the surface coated with the photosensitve composition, a coating composition comprising a water-soluble or water-dispersible resin having a glass transition temperature (Tg) not lower than 20°C. It is postulated, in EP 0335330, that heat generated at the time of conducting the second electrodeposition coating imparts re-flowability to the first electrodeposition coating and repairs any troublesome waterdrop marks which may result after the deposition of the first electrodeposition coating. This two-bath process, however, does not enable control of the quinonediazide content of the deposited film and, therefore, this process may be liable to the problems associated with the process of EP 0315165.

Surprisingly, we have now found that by using a two-bath method, involving the separate sequential deposition of an electrodepositable, non-photosensitive polymer and a naphthoquinone diazide sulphonamide resin, excellent copper coatings can be obtained with much more control over the quinone diazide sulphone functionality.

Accordingly, the present invention provides a method of producing a positive image on a substrate, which method comprising the steps of a) immersing a copper-clad laminate, as a cathode, in an electrolytic bath containing an electrodepositable, non-photosensitive polymer, and electro-depositing a film of the polymer on to the copper-clad laminate; b) immersing the copper-clad laminate, coated with a non-photosensitive polymer in step a), as an anode or, preferably as a cathode, in an electrolytic bath containing a naphthoquinone diazide sulphonamide of formula I:

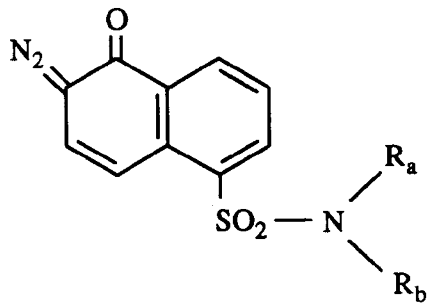

I

in which $R_a$ and $R_b$, independently, are hydrogen provided that $R_a$ and $R_b$ are not both hydrogen; $C_1$-$C_8$ alkylene substituted by an amino group; a phenyl group which is substituted by an amino-containing group; or $R_a$ and $R_b$ together form a 5- or 6- heterocyclic ring which either contains an amino - containing group within the ring, or has an amino-containing group substituted on the ring, and electro-depositing a film of the sulphonamide on to the polymer-coated copper-clad laminate; c) irradiating the dried, coated laminate obtained in step b) through a mask; and d) developing the irradiated, coated laminate to produce a positive image of the mask.

Any amino group-containing polymer which is base soluble may be used as the electrodepositable, non-photosensitive polymer in step a) of the method of the present invention.

Examples of electrodepositable, non-photosensitive polymers useful in the electrolytic bath of step a) of the method of the present invention are reaction products of an epoxide resin with a primary or secondary monoamine or a secondary diamine, particularly a reaction product of an epoxy resin, such as a diglycidyl ether of 2,2-bis(4-hydroxy-phenyl) propane (bisphenol A), with an alkanolamine such as ethanolamine, diethanolamine or propanolamine; reaction produce of an phenolic hydroxyl group-containing resin, such as a novolak resin, a polymer of an ethylenically unsaturated phenol or a phenolic hydroxyl-terminated adduct of an epoxide resin and a bisphenol, with an aldehyde and a primary or secondary amine, for example reaction products of a novolak resin or a poly(vinyl)phenol with an aldehyde such as acetaldehyde, benzaldehyde or, preferably, formaldehyde, and an amine such as a dialkylamine, an alkylene-diamine or an alkanolamine; polymers of basic group-containing acrylic materials such as homopolymers of dialkylaminoalkyl acrylates or methacrylates and copolymers thereof, including copolymers with other vinyl monomers, such as alkyl acrylates or methacrylates, and graft copolymers with acrylate or methacrylate group-containing resins such as esters of epoxide resins with acrylic or methacrylic acid; and Michael addition reaction products of acrylate or methacrylate group-containing resins with a primary or secondary amine such as ethanolamine, diethanolamine or morpholine.

Preferred electrodepositable, non-photosensitive polymers are novolak resins such as phenol-formaldehyde and cresol-formaldehyde which have been reacted with an aldehyde and an amine, or an aldehyde and an amino-carboxylic acid.

Electrodeposition of the non-photosensitive polymer, in step a) of the method of the present invention, may be carried out by any conventional technique. For example, the polymer, optionally together with conventional additives such as pigments, dyes, fillers and plasticizers, can be dissolved or dispersed in an aqueous medium.

The aqueous medium preferably also contains a hydrophilic organic solvent, e.g. isopropanol, n-butanol, t-butanol, methoxyethanol, ethoxyethanol, n-butoxy ethanol, diethylene glycol, methyl ether, acetone, dioxane or tetrahydrofuran. Generally, the amount of the hydrophilic solvent ranges from 2 to 40%, preferably from 5 to 20% by weight of the electrodeposition medium.

There may also be added to the electrodeposition medium a hydrophobic solvent, examples of which include hydrocarbon solvents such as toluene or xylene; ketones such as cyclohexanone or methyl isobutyl ketone; esters such as ethyl acetate or butyl acetate; and hydrophobic alcohols such as n-decanol or 2-ethylhexyl alcohol. Generally, the amount of any hydrophobic solvent will range from 0 to 10%, preferably from 1 to

5% by weight, based on the weight of the electrodeposition medium.

The non-photosensitive polymer also requires the addition of an organic or inorganic acid. Examples of such acids include formic acid, acetic acid, lactic acid, p-toluene sulphonic acid, hydrochloric acid and phosphonic acid, or mixtures of these.

The copper-clad laminate, on to which the non-photosensitive polymer film is to be deposited, may be immersed in the electrodeposition medium as a cathode; and an anode, e.g. a tin-plated steel sheet may be immersed in the medium, and a current passed between the electrodes in order to electrodeposit the polymer on the cathode.

Electrodeposition for only a few minutes, usually one minute, at an amperage of up to 0.1 amp is sufficient in most cases. Amperage of as little as 0.01 amp may be used in some cases, especially if the size of the cathode, on which the polymer is deposited, is small in relation to the anode. Adhesion of the polymer film on to the cathode may be improved by conducting the electrodeposition in two stages: the first at a low amperage, and the second at a higher amperage.

The laminate coated with polymer is preferably rinsed in water prior to use in step b) of the method of the present invention.

The naphthoquinone diazide sulphonamides of formula I are mostly known compounds having been described in JP-150127 (J63006070A). The compounds of formula I may be prepared, e.g. by reacting 2-naphthoquinone diazide-5-sulphonyl chloride with an amine of formula $R_a$ $R_b$ NH in which $R_a$ and $R_b$ have their previous significance.

When $R_a$ and/or $R_b$ is $C_1$-$C_8$ alkylene substituted by an optionally substituted amino group, preferred examples of such groups -N $R_a$ $R_b$ include those having the formulae:

$$- NH(CH_2)_n NH_2$$

wherein n is an integer from 1 to 8, preferably from 1 to 4;

$$- NH(CH_2)_n NR_c R_a$$

wherein n has its previous significance and $R_c$ and $R_d$, independently are hydrogen provided $R_c$ and $R_c$ are not both hydrogen, $C_1$-$C_4$ alkyl, preferably methyl or ethyl, hydroxy - ($C_1$-$C_4$ alkyl), especially hydroxyethyl, or a group of formula:

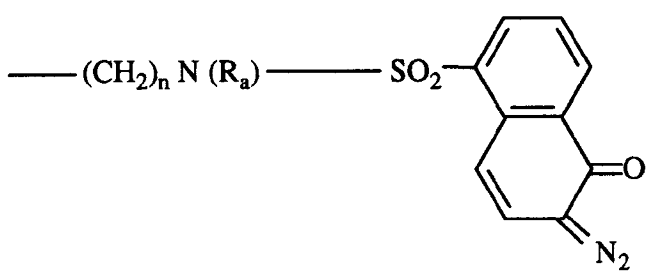

in which n and $R_a$ have their previous significance.

When $R_a$ and/or $R_b$ is a phenyl group which is optionally substituted by an amino - containing group it may be a phenyl or aminophenyl group.

Examples of heterocyclic rings formed by $R_a$ and $R_b$ which have an amino-containing group within the ring include piperazine, 1-methylpiperazine, 2,6-dimethylpiperazine, 1-n-propylpiperazine, 2,5-dimethylpiperazine, 2-methylpiperazine, 2,4,6-trimethylpiperazine, N-beta-hydroxyethylpiperazine and 1-piperazine propanol. Examples of heterocyclic rings formed by $R_a$ and $R_b$ onto which an amino-containing group has been substituted include pyrrolidine, 2-(aminomethyl)-1-ethylpyrrolidine, N-(2-aminoethyl) pyrrolidine, 2-(2-aminoethyl)-1-methylpyrrolidine; and piperidine, 4-piperidino-piperidine, 4,4$^1$-bipiperidine, 4,4$^1$-trimethylenepiperidine, 4,4$^1$-ethylenedipiperidine and 1-(2-aminoethyl)piperidine.

Electrodeposition of the compound of formula I, in step b) of the method of the present invention, may be performed by any conventional technique. For example, the compound of formula (I) may be dissolved or dispersed in an aqueous medium. The aqueous medium preferably contains a hydrophilic solvent, optionally a hydrophobic solvent, and an organic or inorganic acid of the type, and in an amount, similar to those indicated for step a) of the method of the present invention.

The copper-clad laminate, having been coated with a non-photosensitive polymer in step a) of the method of the present invention, and on to which the compound of formula I is to be deposited, may be immersed as an anode but preferably as a cathode into the aqueous medium, and a cathode or, preferably an anode, e.g. a tin-plated steel plate, may be immersed in the medium. By passing a current between the electrodes, the compound of formula I is electrodeposited on to the polymer-coated laminate electrode, preferably a cathode.

The electrodeposition conditions in step b) of the method of the present invention are broadly similar to those used in step a) of the method of the invention.

The coated laminate obtained in step b) of the method of the invention is removed from the electrodeposition bath of step b), preferably rinsed with water and dried, e.g. by heating. The electrodeposited film so obtained is a tack-free solid layer having a thickness of, e.g. up to 10 microns.

Irradiation of the dried photosensitive layer obtained in step b), in a predetermined pattern, may be achieved by exposure through an image-bearing transparency (mask) comprising some substantially opaque areas and also areas which are substantially transparent to the radiation used. Alternatively, the irradiation may be effected by means of a computer-controlled laser beam. Electromagnetic radiation having a wavelength ranging from 200 to 600 nm is generally used, and suitable sources include carbon arcs, mercury vapour arcs, fluorescent lamps with phosphors emitting ultra violet light, argon and xenon glow lamps, tungsten lamps and photographic flood lamps. Of these, mercury vapour arcs and metal halide lamps are the most suitable. Suitable exposure times and source/mask spacings can be readily determined by routine experimentation.

In step d) of the method of the present invention, removal of the exposed areas of the irradiated layer is preferably performed by treatment with a solvent, preferably a basic aqueous solution, in particular an aqueous solution, in particular an aqueous solution of sodium or potassium hydroxide, or sodium or potassium carbonate. Such development of the irradiated layer produces a clear positive image of the mask.

Copper exposed by the development procedure may be removed by any conventional etchant, e.g. ferric chloride, hydrogen peroxide/phosphoric acid, ammonium persulphate or cupric chloride. After etching, the space of the copper-clad laminate comprises predetermined areas of copper covered by the electrodeposited films, and areas in which the laminate is devoid of copper.

The method of the invention is particularly suitable for the production of printed circuits, including multilayer printed circuits having plated through holes or vias.

The invention is further illustrated by the following Examples.

Resin I

A novolak (100 g), prepared from phenol (2.25 mols), p-tert.butyl phenol (0.75 mol), and formaldehyde (2.7 mols), is dissolved in 2-n-butoxyethanol (150 g), and heated to 70°C. A solution containing diethanolamine (15.8 g, 150 mmol), formalin (23.1 g, 38.83% HCHO), lactic acid (18 g, 150 mmol), and 2-n-butoxyethanol (25 g) is added, and the mixture maintained at 70°C for 5 hours.

The reaction mixture is then diluted with water (100 g), cooled to room temperature, and poured slowly into stirred 0.16M sodium carbonate solution (6000 ml). The resulting precipate is filtered off, washed with water, and dried under vacuum to give 120.5 g of Resin I.

Resin II

A novolak (50 g), prepared from phenol (2.25 mols), p-tert.butyl phenol (0.75 mols), and formaldehyde (2.7 mols), is dissolved in 2-n-butoxyethanol (75 g), and a mixture of formalin (11.5 g, 38.83% HCHO), lactic acid (18 g, 150 mmol,) and morpholine (13 g, 150 mmol) is added, and the mixture maintained at 70°C for 2 hours.

The solution is then diluted with water (50 ml), cooled to room temperature, and poured slowly into stirred 0.31M sodium carbonate solution (3000 ml). The resulting precipitate is filtered off, washed with water, and dried under vacuum to give 62g of Resin II.

Resin III

A novolak (50 g), prepared from phenol (2.4 mols), bisphenol A (0.60 mols), and formaldehyde (2.7 mols), is dissolved in 2-n-butoxyethanol (60 g) and heated to 60°C. Diethanolamine (13 g, 125 mmol) is added, and then a solution containing formalin (12 g, 38.83% HCHO) and lactic acid (11 g, 85 mmol), and the mixture maintained at 60°C for 3 hours. The mixture is then diluted with water (50 ml), cooled to room temperature, and poured slowly into stirred 0.47M sodium carbonate solution (2000 ml). The resulting precipitate is filtered off, washed with water, and dried under vacuum to give 48.3 g of Resin III.

Resin IV

A novolak (40 g), prepared from phenol (2.4 mols), bisphenol A (0.60 mols), and formaldehyde (2.7 mols), is dissolved in 2-n-butoxyethanol (60 g) and heated at 60°C. Morpholine (10 ml, 114 mmol) is added, and then a solution containing formalin (12 g, 38.83% HCHO), and lactic acid (22 g, 17 mmol), and the mixture maintained

at 60°C for 2.5 hows.

The mixture is diluted with water (50 ml), cooled to room temperature, and poured slowly into stirred 0.47M sodium carbonate solution (2000 ml). The resulting precipitate is filtered off, washed with water, and dried under vacuum to give 58 g of Resin IV.

Resin V

A novolak (50 g), prepared from phenol (2.25 mols), p-tert.butyl phenol (0.75 mols), and formaldehyde (2.7 mols), is dissolved in 2-n-butoxyethanol (60 g), and heated to 60°C. Formalin (9 g, 38.83% HCHO) is added, followed by a mixture of diethanolamine (6 g, 57 mmol), lactic acid (8 g, 66 mmol), and 2-n-butoxyethanol (10 g) is added and the mixture maintained at 60°C for 6 hours, and then allowed to cool.

Resin VI

A) Preparation of N-(4-hydroxyphenyl) maleimide starting material used in preparation of Resin VI

To a solution of 4-aminophenol (21.8g) in dimethylformamide (80 ml), stirred under nitrogen, is slowly added maleic anhydride (21.6g), keeping the temperature below 50°C. At the end of the addition, the solution is stirred for 1½ hows at room temperature. Phosphorus pentoxide (11.4g) and concentrated sulphuric acid (5g) are slowly added, and the mixture is heated at 80°C for 3 hows. The reaction mixture is allowed to cool and is poured into a mixture of ice and water (500 ml). The solid is collected by filtration and recrystallised from isopropanol to give 24.9g of the desired product.

B) Preparation of Resin VI

Methyl methacrylate (25.5g), N-(4-hydroxyphenyl) maleimide (1.5g) and WAKO V65 (2,2$^1$-azobis (2,4-dimethyl valeronitrile) (2g) in n-butoxy ethanol (60g) is stirred at 70°C for 2 hours, V65 (0.5g) added and the reaction mixture is stirred for a further 2 hours to produce Resin VI.

Resin VII

A novalak is prepared from phenol (2.25 mols), p-tert butyl phenol (0.75 mol) and formaldehyde (2.7 mols) to produce Resin VII.

Resin VIII

A mixture of bisphenol A (118g) and bisphenol A diglycidyl ether, epoxy value 5.3 mol/kg (134g) is heated to 140°C and triphenyl ethyl-phosphonium iodide (0.1g) is added. The reaction is heated for 2 hours at 140°C and then at 150°C for 1½ hours. The epoxy value at this time is down to 0.08 mol/kg.

Maleic anhydride (40g) is added to the reaction mixture and the reaction mixture is heated at 160°C for 1½ hours. The resin is then poured out hot into a tin-foil tray.

| | |
|---|---|
| Yield | = 252g |
| Acid value | = 1.01 g/kg |
| Tg | = 55.7°C |

Solution Inhibitor I

To a solution of 2-naphthoquinonediazide-5-sulphonyl chloride (6.5 g, 0.027 mols), and N-methylpiperazine (4 ml, 0.036 mols), in dichloromethane (100 ml), is added dropwise, 10% aqueous sodium carbonate solution (100 g). The reaction mixture is stirred at 30°C for 1 hour and allowed to cool.

The organic layer is separated, washed with water (2 x 500 ml), dried ($MgSO_4$), and the dichloromethane removed by distillation under reduced pressure to give 5.3 g (67%) of Solution Inhibitor I as an orange solid, m.p. 143°C (dec.).

$^1$H NMR ($CD_3COCD_3$) δ 2.20 (s,3H), 2.40 (m,4H), 2.90 (m,4H), 7.50 (s,2H), 7.70 (t,1H), 8.30 (d,1H), 8.60 (d,1H).

IR (KBr disc): 2950, 2800, 2160, 2130, 1620, 1610, 160, 1570, 1540, 1460, 1430, 1400, 1380, 1330, 1310, 1290, 1260, 1230, 1200, 1160, 1140, 1090, 1070, 1060, 1010, 950, 940, 800, 720, 700, 660, 640, 600 $cm^{-1}$.

Solution Inhibitor II

To a solution of 2-naphthoquinonediazide-5-sulphonyl chloride (6.5 g, 24 mmols), and N,N-dimethylethylenediamine (3 ml, 27 mmols), in dichloro-methane (150 ml), is added dropwise, 10% aqueous sodium carbonate solution (100 g). The reaction is stirred at 30°C for 1 hour and allowed to cool.

The organic layer is separated, washed with water (2 x 500 ml), dried ($MgSO_4$), and the dichloromethane removed by distillation under reduced pressure to give 5.0 g (65%) of Solution Inhibitor II as an orange solid, m.p. 120°C (dec.).

$^1H$ NMR ($CDCl_3$) δ 2.00 (s,6H), 2.25 (t,2H), 2.95 (t,2H), 7.05 (d,1H), 7.45 (d,1H), 7.55 (t,1H), 8.35 (d,1H), 8.60 (d,1H).

IR (KBr disc): 330, 2990, 2970, 2860, 2840, 2790, 2720, 2160, 2100, 1660, 1600, 1560, 1540, 1470, 1430, 1400, 1330, 1270, 1210, 1190, 1150, 1120, 1110, 1100, 1080, 1050, 1040, 970, 930, 880, 830, 800, 770, 760, 70, 660, 600 $cm^{-1}$.

Solution Inhibitor III

To a solution of 2-naphthoquinonediazide-5-sulphonyl chloride (6.5 g, 24 mmol), and 4(2-aminoethyl)-morpholine (4 ml, 30 mmol), in dichloromethane (150 ml), is added dropwise, 10% aqueous sodium carbonate solution (100 g). The reaction mixture is heated at 30°C for 1 hour and allowed to cool.

The organic layer is separated, washed with water (2 x 500 ml), dried ($MgSO_4$), and the dichloromethane removed by distillation under reduced pressure to give 7.0g (81%) of Solution Inhibitor III as an orange solid, m.p. 137°C (dec.).

$^1H$ NMR ($CDCl_3$) δ 2.20 (m,4H), 2.30 (m,2H), 2.95 (m,2H), 3.60 (m,4H), 7.05 (d,1H), 7.45 (d,1H), 7.55 (t,1H), 8.35 (d,1H), 8.60 (d,1H).

IR (KBr disc): 3250, 3180, 2940, 2880, 2820, 2160, 2120, 1620, 1600, 1570, 1530, 1460, 1440, 1400, 1390, 1360, 1340, 1320, 1300, 1260, 1230, 1220, 1190, 1160, 1150, 1140, 1120, 1090, 1070, 1020, 950, 920, 870, 850, 830, 800, 770, 700 $cm^{-1}$.

Solution Inhibitor IV

To a solution of 2-naphthoquinonediazide-5-sulphonyl chloride (6.5 g, 24 mmol), and 3-dimethylaminopropylamine (3 ml, 24 mmol), in dichloromethane (150 ml), is added dropwide, 10% aqueous sodium carbonate solution (100 g). The reaction mixture is heated at 30°C for 1 hour and allowed to cool.

The organic layer is separated, washed with water (2 x 500 ml), dried ($MgSO_4$), and the dichloromethane removed by distillation under reduced pressure to give 6.2 g (77%) of Solution Inhibitor IV as an orange solid, m.p. 116°C (dec.).

$^1H$ NMR ($CDCl_3$) δ 1.60 (m,2H), 2.20 (s,6H), 2.30 (t,2H), 3.00 (t,2H), 7.05 (d,1H), 7.45 (d,1H), 7.55 (t,1H), 8.35 (d,1H), 8.60 (d,1H).

IR (KBr disc): 3300, 2980, 2960, 2800, 2760, 2170, 2140, 2120, 1610, 1570, 1470, 1440, 1400, 1330, 1310, 1270, 1260, 1200, 1190, 1150, 1110, 1100, 1090, 1060, 1040, 970, 900, 810, 780, 750, 690, 650$cm^{-1}$.

Solution Inhibitor Electrodeposition Bath I

Solution Inhibitor I (1 g) is dissolved in a mixture of 12% aqueous lactic acid (2.5 g), 2-n-butoxyethanol (10 g), and water (86.5 g), to give a dark solution having a 1% solids content.

Solution Inhibitor Electrodeposition Bath II

Solution Inhibitor I (2 g) is dissolved in a mixture of 12% aqueous lactic acid (4.5 g), 2-n-butoxyethanol (12.5 g), and water (81 g), to give a dark solution having a 2% solids content.

Solution Inhibitor Electrodeposition Bath III

Solution Inhibitor II (1 g) is dissolved in a mixture of 12% aqueous lactic acid (2.5 g), 2-n-butoxyethanol (10 g), and water (86.5 g), to give a dark solution having a 1% solids content.

Solution Inhibitor Electrodeposition Bath IV

Solution Inhibitors III (1 g) is dissolved in a mixture of 12% aqueous lactic acid (2.0 g), 2-n-butoxyethanol (10 g), and water (87 g), to give a dark solution having a 1% solids content.

Solution Inhibitor Electrodeposition Bath V

Solution Inhibitor IV (1 g) is dissolved in a mixture of 12% aqueous lactic acid (2.5 g), 2-n-butoxyethanol (10 g), and water (86.5 g), to give a dark solution having a 1% solids content.

Solution Inhibitor Electrodeposition Bath VI

2-Naphthoquinone diazide-5-sulphonic acid sodium salt (1g) is dissolved in a mixture of 2-n-butoxy ethanol (10g) and water (89g) to give a reddish solution having a 1% solids content.

Solution Inhibitor Electrodeposition Bath VII

2-Naphthoquinone diazide-5-sulphonic acid sodium salt (5g) is dissolved in a mixture of 2-n-butoxy ethanol (10g) and water (85g) to give a reddish solution having a 5% solids content.

Solution Inhibitor Electrodeposition Bath VIII

Solution Inhibitor I (1g) is dissolved in a mixture of 12% aqueous lactic acid (2.5g), 2-n-butoxy ethanol (5g), acetone (5g) and water (86.5g) to give a red solution having a 1% solids content.

Solution Inhibitor Electrodeposition Bath IX

Solution Inhibitor I (1g) is dissolved in a mixture of 2-n-butoxy ethanol (10g), p-toluene sulphonic acid (0.6g) and water (88.4g) to give a red solution having a 1% solids content.

Example 1

Resin I (10 g) is added slowly, with stirring, to 2-n-butoxyethanol (12.5 g). The mixture is added to a mixture of 12% aqueous lactic acid (4.5 g) and distilled water (73 g) to give a dispersion having 10% solids content. A copper-clad laminate and a tin-plated steel sheet are immersed in the dispersion as cathode and anode respectively. An electric current is passed through at a constant 0.01 amps for 15 minutes to deposit a resinous film on the laminate.

The laminate is removed from the dispersion, rinsed in water and immersed in Solution Inhibitor Electrodeposition Bath II, with a tin-plated steel sheet, as cathode and anode respectively. An electric current is passed through at a constant 0.01 amps for 60 seconds.

The laminate is removed from the dispersion, rinsed in water, and dried at 90°C for 5 minutes, after which the electrodeposited film is a tack-free solid layer having a thickness of 6 micrometers. The dried film is irradiated through a mask for 30 seconds, using a 5000W metal halide lamp at a distance of 75 cm. Development of the irradiated film by immersion in aqueous 2% sodium hydroxide solution gives a clear positive image of the mask. The copper exposed by development is removed by etching in an aqueous 40% solution of ferric chloride at 30°C.

Example 2

Resin II (10g) is added slowly, with stirring, to a mixture of 2-n-butoxyethanol (12.5 g), and 12% aqueous lactic acid (7.5 g). This mixture is added to water (70 g) and xylene (1 g) is added to give a dispersion having 10% solids content. A copper-clad laminate and a tin-plated steel sheet are immersed in the dispersion as cathode and anode respectively. An electric current is passed through at a constant 0.04 amps for 60 seconds to deposit a resinous film on the laminate.

The laminate is removed from the dispersion, rinsed in a mixture of water and butoxyethanol (volume ratio 9:1), and immersed in Solution Inhibitor Electrodeposition Bath I, with a tin-plated steel sheet, as cathode and anode respectively. An electric current is passed through at a constant 0.04 amps for 1 minute.

The laminate is removed from the solution, rinsed in a mixture of water and 2-n-butoxyethanol (volume ratio

9:1), and dried at 90°C for 5 minutes, after which the electroposited film is a tack-the solid layer having a thickness of 9 micrometers. The dried film is irradiated through a mask for 30 seconds, using a 5000W metal halide lamp at a distance of 75 cm. Development of the irradiated film by immersion in aqueous 2% sodium hydroxide gives a clear positive image of the mask.

Example 3

Resin III (10 g) is added slowly, with stirring, to 2-n-butoxyethanol (12.5 g). This mixture is added to a mixture of 12% aqueous lactic acid (6.8 g) and distilled water (70.7 g) to give a dispersion having 10% solids content. A copper-clad laminate and a tin-plated steel sheet are immersed in the dispersion as cathode and anode respectively. An electric current is passed through at a constant 0.02 amps for 3 minutes to deposit a resinous film on the laminate.

The laminate is removed from the dispersion, rinsed in distilled water and immersed in Solution Inhibitor Electrodeposition Bath I, with a tin-plated steel sheet, as cathode and anode respectively. An electric current is passed through at a constant 0.02 amps for 60 seconds.

The laminate is removed from the solution, rinsed in distilled water and dried at 90°C for 5 minutes, after which the electrodeposited film is a tack-free solid layer having a thickness of 10 micrometers. The dried film is irradiated through a mask for 30 seconds, using a 5000W metal halide lamp at a distance of 75 cm. Development of the irradiated film by immersion in aqueous 1% sodium hydroxide gives a clear positive image of the mask.

The copper exposed by development is removed by etching in an aqueous 40% solution of ferric chloride at 30°C.

Example 4

Resin IV (10 g) is added slowly, with stirring, to 2-n-butoxyethanol (12.5 g). This mixture is added to a solution of 12% aqueous lactic acid (7.4 g) and distilled water (70.1 g), to give a dispersion having 10% solids content. A copper-clad laminate and a tin-plated steel sheet are immersed in the dispersion as cathode and anode respectively. An electric current is passed through at a constant 0.02 amps for 3 minutes to deposit a resinous film on the laminate.

The laminate is removed from the dispersion, rinsed in distilled water and immersed in Solution Inhibitor Electrodeposibon Bath I, with a tin-plated steel sheet, as cathode and anode respectively. An electric current is passed through at a constant 0.02 amps for 60 seconds.

The laminate is removed from the solution, rinsed in distilled water and dried at 90°C for 5 minutes, after which the electrodeposited film is a tack-free solid having a thickness of 8 micrometers. The dried film is irradiated through a mask for 30 seconds, using a 5000W metal halide lamp at a distance of 75 cm. Development of the irradiated film by immersion in aqueous 1% sodium hydroxide gives a clear positive image of the mask.

The copper exposed by development is removed by etching in an aqueous 40% solution of ferric chloride at 30°C.

Example 5

Resin Solution V (23 g) is added slowly, with stirring, to distilled water (77 g) to give a dispersion having 10% solids content. A copper-clad laminate and a tin-plated steel sheet are immersed in the dispersion as cathode and anode respectively. An electric current is passed through at a constant 0.04 amps for 30 seconds to deposit a resinous film on the laminate.

The laminate is removed from the dispersion, rinsed in distilled water and immersed in Solution Inhibitor Electrodeposition Bath III, with a tin-plated steel sheet, as cathode and anode respectively. An electric current is passed through at a constant 0.02 amps for 60 seconds.

The laminate is removed from the solution, rinsed in distilled water and dried at 90°C for 5 minutes, after which the electrodeposited film is a tack-free solid having a thickness of 14 micrometers.

The dried film is irradiated through a mask for 30 seconds, using a 5000W metal halide lamp at a distance of 75 cm. Development of the irradiated film by immersion in aqueous 2% sodium hydroxide gives a clear positive image of the mask.

Example 6

Resin Solution V (23 g) is added slowly, with stirring, to distilled water (77 g) to give a dispersion having

10% solids content. A copper-clad laminate and a tin-plated steel sheet are immersed in the dispersion as cathode and anode respectively. An electric current is passed through at a constant 0.04 amps for 30 seconds to deposit a resinous film on the laminate

The laminate is removed from the dispersion, rinsed in distilled water and immersed in Solution Inhibitor Electrodeposition Bath IV, with a tin-plated steel sheet, as cathode and anode respectively. An electric current is passed through at a constant 0.02 amps for 60 seconds.

The laminate is removed from the solution, rinsed in distilled water and dried at 90°C for 5 minutes, after which the electrodeposited film is a tack-the solid having a thickness of 13 micrometers.

The dried film is irradiated through a mask for 30 seconds, using a 5000W metal halide lamp at a distance of 75 cm. Development of the irradiated film by immersion in aqueous 2% sodium hydroxide gives a clear positive image of the mask.

Example 7

Resin Solution V (23 g) is added slowly, with stirring, to distilled water (77 g) to give a dispersion having 10% solids content. A copper-clad laminate and a tin-plated steel sheet are immersed in the dispersion as cathode and anode respectively. An electric current is passed through at a constant 0.04 amps for 30 seconds to deposit a resinous film on the laminate.

The laminate is removed from the dispersion, rinsed in distilled water and immersed in Solution Inhibitor Electrodeposition Bath V, with a tin-plated steel sheet, as cathode and anode respectively. An electric current is passed through at a constant 0.02 amps for 60 seconds.

The laminate is removed from the solution, rinsed in distilled water and dried at 90°C for 5 minutes, after which the electrodeposited film is a tack-free solid having a thickness of 10 micrometers.

The dried film is irradiated through a mask for 30 seconds, using a 5000W metal halide lamp at a distance of 75 cm. Development of the irradiated film by immersion in aqueous 2% sodium hydroxide gives a clear positive image of the mask.

Example 8

Resin solution V (23g) is added slowly, with stirring, to distilled water (77g) to give a dispersion having 10% solids content. A copper-clad laminate and a tin-plated steel sheet are immersed in the dispersion as cathode and anode, respectively. An electric current is passed through at a constant 0.04 amps for 75 seconds to deposit a resinous film on the laminate.

The laminate is removed from the dispersion, rinsed in distilled water and immersed in Solution Inhibitor Electrodeposition Bath I, with a tin-plated steel sheet, as cathode and anode respectively. An electric current is passed through at a constant 0.02 amps for 90 seconds.

The laminate is removed from the solution, rinsed in distilled water and added at 90°C for 5 minutes, after which the electrodeposited film is a tack-free solid having a thickness of 8 micrometers. The dried film is irradiated through a mask for 30 seconds, using a 5000 w metal halide lamp at a distance of 75 cm. Development of the irradiated film by immersion in aqueous 2% sodium hydroxide gives a clear positive image of the mask.

The copper exposed by development is removed by etching in an aqueous 15% solution of ammonium persulphate at 50°C.

Example 9

Resin solution V (23g) is added slowly, with stirring, to distilled water (77g) to give a dispersion having 10% solids content. A copper clad laminate and a tin-plated steel sheet are immersed in the dispersion as cathode and anode respectively. An electric current is passed through at a constant 0.04 amps for 90 seconds to deposit a resinous film on the laminate.

The laminate is removed from the dispersion, rinsed in distilled water and immersed in Solution Inhibitor Electrodeposition Bath VI, with a tin-plated steel sheet, as anode and cathode, respectively. An electric current is passed through at a constant 0.02 amps for 90 seconds.

The laminate is removed from the solution, rinsed in distilled water and dried at 90°C for 5 minutes, after which the electrodeposited film is a tack-free solid having a thickness of 11 micrometers. The dried film is irradiated through a mask for 30 seonds using a 5000w metal halide lamp at a distance of 75 cm. Development of the irradiated film by immersion in aqueous 2% sodium hydroxide gives a clear positive image of the mask.

Example 10

A solution of Resin VI (25g) and 10% aqueous triethanolamine (25.8g) is slowly added, with stirring, to water (49.2g) to give a solution of 10% solids content. A copper-clad laminate and a tin-plated steel sheet are immersed in the solution as anode and cathode respectively. An electric current is passed through at 10 volts for 3 seconds depositing a resinous film on the laminate.

The laminate is removed, rinsed in water and immersed in Solution Inhibitor Electrodeposition Bath I, with a tin-plated steel sheet, as cathode and anode respectively. An electric current is passed through at a constant 0.02 amps for 90 seconds.

The laminate is removed, rinsed in water, and dried at 90°C for 5 minutes, after which the electrodeposited film is a tack-free coating of 8 micrometer thickness. The film is irradiated for 30 seconds through a mask, using a 5000 w metal-halide lamp at a distance of 75 cm. Development in 1% sodium hydroxide solution produces a clear positive image of the mask.

Example 11

To Resin VII (10g) is added, with stirring, 2 n butoxy ethanol (10g), followed by 20% aqueous potassium hydroxide (6.9g). This mixture is added to distilled water (73.1g) and n-decanol (4g) with stirring, to give a solution of 10% solids content. A copper-clad laminate and a tin-pated steel sheet are immersed in the solution as anode and cathode respectively. An electric current is passed through at 50 volts for 1 second to deposit a resinous film on the laminate.

The laminate is removed, rinsed in water and immersed in Solution Inhibitor Electrodeposition Bath I, with a tin-plated steel sheet as cathode and anode respectively.

An electric current is passed through at a constant 0.02 amps for 5 seconds. The laminate is removed, rinsed in water and dried at 90°C for 5 minutes, after which the electrodeposited film is a tack-free layer having a thickness of 4 micrometers. The film is irradiated through a mask for 30 seconds, using a 5000 w metal-halide lamp at a distance of 75 cm. Development by immersion in 1% sodium hydroxide solution gives a clear positive image of the mask.

Example 12

To Resin VII (10g) is added, with stirring, 2-n-butoxy ethanol (10g), followed by 20% aqueous potassium hydroxide (6.0g). This mixture is added to distilled water (73.1g) and n-decanol (4g) with stirring, to give a solution having 10% solids content. A copper-clad laminate and a tin-plated steel sheet are immersed into the solution as anode and cathode respectively. An electric current is passed through at 100 volts for 0.25 seconds to deposit a resinous film on the laminate.

The laminate is removed from the solution, rinsed in water and immersed in Solution Inhbitor Electrodeposition Bath VII, with a tin-plated steel sheet as anode and cathode respectively. An electric current is passed through at a constant 0.02 amps for 60 seconds. The laminate is removed, rinsed in water and dried at 90°C for 5 minutes, after which the electrodeposited film is a tack-free layer having a thickness of 5 micrometers. The film is irradiated through a mask for 30 seconds, using a 5000 w metal-halide lamp at a distance of 75 cm. Development in 0.5% sodium hydroxide solution gives a clear positive image of the mask.

Example 13

Resin I (10g) is added slowly, with stirring, to 2-n-butoxy ethanol (12.5g). 12% aqueous lactic acid (4.5g) is added to this before the mixture is added to distilled water (72g) and finally n-decanol (1g) is added, to give a dispersion having 10% solids content. A copper-clad laminate and a tin-plated steel sheet are immersed in the dispersion as cathode and anode respectively. An electric current is passed through at a constant 0.02 amps for 120 seconds to deposit a resinous film on the laminate.

The laminate is removed, rinsed in water and immersed in Solution Inhibitor Electrodeposition Bath I, with a tin-plated steel sheet, as cathode and anode respectively. An electric current is passed through at a constant 0.02 amps for 90 seconds. The laminate is removed, rinsed in water and dried at 90°C for 5 minutes, after which the electrodeposited film is a tack-free solid layer having a thickness of 6 micrometers. The dried film is irradiated through a mask for 30 seconds, using a 5000 w metal halide lamp at a distance of 75 cm. Development in a 2% aqueous sodium hydroxide solution containing 1% 2-n-butoxy ethanol gives a clear positive image of the mask.

Example 14

Resin I (10g) is added slowly to 2-n-butoxy ethanol (12.5g). To this is added 10% aqueous concenaated hydrochloric acid (6g). This mixture is then added with stirring to distilled water (71.5g), to give a dispersion having 10% solids content. A copper-clad laminate and a tin-plated steel sheet are immersed in the dispersion as cathode and anode respectively. An electric current is passed through at a constant 0.02 amps for 120 seconds to deposit a resinous film on the laminate.

The laminate is removed from the dispersion, rinsed in water and immersed in Solution Inhibitor Electrodeposition Bath I, with a tin-plated steel sheet as cathode and anode respectively. An electric current is passed through at a constant 0.02 amps for 90 seconds.

The laminate is removed, rinsed in water and dried at 90°C for 5 minutes, after which a tack-free coating of 10 micrometers is obtained. The dried film is irradiated through a mask for 30 seconds, having a 5000 w metal halide lamp at a distance of 75 cm. Development in aqueous 2% sodium hydroxide solution gives a clear positive image of the mask.

Example 15

Resin I (10g) is dissolved in a mixture of isopropanol (6g) and 2-n-butoxy ethanol (6.5g). To this is added 12% aqueous lactic acid solution (6.8g) and then this mixture is added with stirring, to distilled water (74.1g) to give a dispersion having 10% solids content. A copper-clad laminate and a tin-plated steel sheet are immersed in the dispersion as cathode and anode respectively. An electric current is passed through at 100 volts for 3 seconds to deposit a reinous film on the laminate.

The laminate is removed, rinsed in water and immersed in Solution Inhibitor Electrodeposition Bath I, with a tin-plated steel sheet as cathode and anode respectively. An electric current is passed through at a constant 0.02 amps for 90 seconds.

The laminate is removed, rinsed in water and dried at 90°C for 5 minutes, giving a tack-free coating of 6 micrometers. The dried film is irradiated through a mask for 30 seconds, using a 5000 w metal halide lamp at a distance of 75 cm. Development of the irradiated film by immersion in aqueous 2% sodium hydroxide solution gives a clear positive image of the mask.

Example 16

Resin I (10g) is dissolved in a mixture of tetrahydrofuran (6g) and 2-n-butoxy ethanol (6.5g) and 12% aqueous lactic acid (3.4g) was added. This mixture is then added, with stirring, to distilled water (74.1g) to give a dispersion having 10% solids content. A copper-clad laminate and a tin-plated steel sheet are immersed in the dispersion as cathode and anode respectively. An electric current is passed through at 50 volts for 3 seconds to deposit a resinous film on the laminate. The laminate is removed, rinsed in water and immersed in Solution Inhibitor Electrodeposition Bath I, with a tin-plated steel sheet, as cathode and anode respectively. An electric current is passed through at a constant 0.02 amps for 90 seconds.

The laminate is removed, rinsed in water and dried at 90°C for 5 minutes, after which the electrodeposited film is a tack-free solid layer of 8 micrometers. The dried film is irradiated through a mask for 30 seconds, using a 5000 w metal halide lamp at a distance of 75 cm. Development in 2% aqueous sodium hydroxide produces a clear positive image of the mask.

Example 17

Resin solution V (23g) is added slowly, with stirring, to distilled water (77g) to give a dispersion having 10% solids content. A copper-clad laminate and a tin-plated steel sheet are immersed in the dispersion as cathode and anode respectively. An electric current is passed through at a constant 0.04 amps for 75 seconds to deposit a resinous film on the laminate. The laminate is removed, rinsed in distilled water and immersed in Solution Inhibitor Electrodeposition Bath VIII, with a tin-plated steel sheet, as cathode and anode respectively. An electric current is passed through at a constant 0.02 amps for 90 seconds. The laminate is removed from the solution, rinsed in distilled water, and dried at 90°C for 5 minutes, to give a tack-free film of 11 micrometers. The dried film is irradiated through a mask for 30 seconds, using a 5000 w metal halide lamp at a distance of 75 cm. Development in 2% aqueous sodium hydroxid produces a clear positive image of the mask.

Example 18

Resin solution V (23g) is added slowly, with stirring, to distilled water (77g) to give a dispersion having 10% solids content. A copper-clad laminate and a tin-plated steel sheet are immersed in the dispersion as cathode and anode respectively. An electric current is passed through at a constant 0.04 amps for 75 seconds, to deposit a resinous film on the laminate.

The laminate is removed, rinsed in distilled water and immersed in Solution Inhibitor Electrodeposition Bath IX, with a tin-plated steel sheet, as cathode and anode respectively. An electric current is passed through at a constant 0.02 amps for 90 seconds.

The laminate is removed, rinsed in distilled water and dried at 90°C for 5 minutes, after which the electrodeposited film is a tack-free solid having a thickness of 9 micrometers.

The dried film is irradiated through a mask for 30 seconds, using a 5000 w metal halide lamp at a distance of 75 cm. Development of the irradiated film by immersion in aqueous 2% sodium hydroxide gives a clear positive image of the mask.

Example 19

Resin VIII (10g) is dissolved in 2-n-butoxy ethanol (12.5g) and to this was added, with stirring, a 10% aqueous triethanolamine solution (15.0g). This solution is then added with stirring to deionised water (62.5g) to give a solution of 10% solids content. A copper-clad laminate and a tin-plated steel sheet are immersed in the solution as anode and cathode respectively. An electric current is passed through at 150 volts for 0.5 seconds depositing a resinous film on the laminate.

The laminate is removed, rinsed in water and immersed in Solution Inhibitor Electrodeposition Bath I as cathode, with a tin-plated steel sheet as anode. An electric current is passed through at a constant 0.02 amps for 90 seconds. The laminate is removed, rinsed in water, and dried at 90°C for 5 minutes, after which the electrodeposited film is a tack-free coating of 5 micrometers. The film is irradiated for 30 seconds through a mask using a 5000 w metal-halide lamp at a distance of 75 cm.

Development in a 2% sodium hydroxide solution containing 4% butoxy ethanol gave a clear positive image of the mask in 90 seconds.

The copper exposed by development can be removed by etching in a Ferric Chloride Bath at 30°C for 2 minutes.

**Claims**

**1.** A method of producing a positive image on a substrate, which method comprises the steps of a) immersing a copper-clad laminate, as a cathode, in an electrolytic bath containing an electrodepositable, non-photosensitive polymer, and electrodepositing a film of the polymer on to the laminate; b) immersing the laminate, coated with the polymer in step a), as an anode or a cathode, in an electrolytic bath containing a naphthoquinone diazide sulphonamide of formula (I):

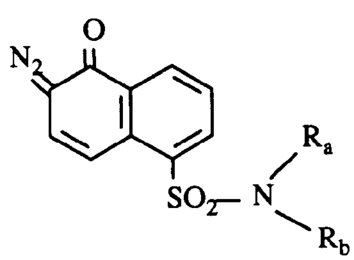

I

in which $R_a$ and $R_b$ independently, are hydrogen, provided that $R_a$a and $R_b$ are not both hydrogen; $C_1$-$C_8$ alkylene substituted by an amino group; a phenyl group which is optionally substituted by an amino-containing group; or $R_a$ and $R_b$ together form a 5- or 6- membered optionally substituted heterocyclic ring which either contains an amino-containing group within the ring, or has an amino-containing group substituted on the ring, and electro, depositing a film of the sulphonamide on to the polymer-coated laminate; c) irradiating the dried, coated laminate obtained in step b) through a mask; and d) developing the irradiated, coated laminate to produce a positive image of the mask.

2. A method according to claim 1 in which the electrodepositable non-photosensitve polymer is an amine-modified novolak resin.

3. A method according to claim 2 in which the novolak resin is a phenol-formaldehyde or cresol formaldehyde which has been reacted with an aldehyde and an amine, or an aldehyde and an aminocarboxylic acid.

4. A method according to any of the preceding claims in which, in step a), the polymer, optionally together with conventional additives, is dissolved or dispersed in an aqueous medium to form an electrodeposition bath.

5. A method according to claim 4 in which the electrodeposition bath in step a) contains a hydrophilic organic solvent; optionally a hydrophobic solvent; and an organic or inorganic acid.

6. A method according to any of the preceding claims in which the naphthoquinone diazide sulphonamide used in step b) has the formula:

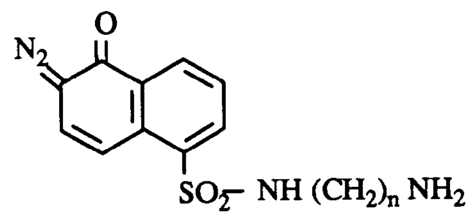

in which n is an integer from 1 to 8.

7. A method according to claim 6 in which n is an integer from 1 to 4.

8. A method according to any of claims 1 to 5 in which the naphthoquinone diazide sulphonamide, used in step b), has the formula:

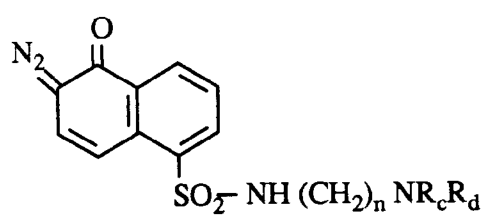

in which n is an integer from 1 to 8, and $R_c$ and $R_d$, independently, are hydrogen, provided that both $R_c$ and $R_c$ are not hydrogen, $C_1$-$C_4$ alkyl hydroxy - ($C_1$-$C_4$) alkyl or a group of formula:

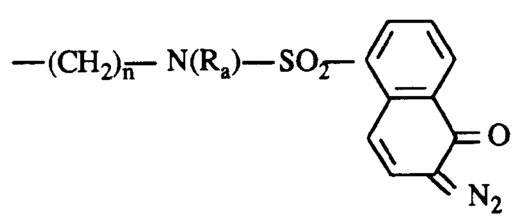

in which n is an integer of from 1 to 10 and $R_a$ is as defined in claim 1.

9. A method as claimed in claim 8 in which alkyl groups $R_c$ and $R_c$ are methyl or ethyl.

10. A method according to any of the preceding claims in which optionally phenyl groups $R_a$ and/or $R_b$ groups are phenyl or aminophenyl groups.

**11.** A method according to any of claims 1 to 9 in which optionally substituted heterocyclic rings formed by $R_a$ and $R_b$ are piperazine or pyrrolidine rings, each optionally substituted by amino($C_1$-$C_4$ alkyl) groups.

**12.** A method according to any of the preceding claims in which, in step b), the laminate coated with the polymer in step a), is immersed as a cathode in step b).

**13.** A method according to any of the preceding claims in which, in step b), the compound of formula I, optionally together with conventional additives, is dissolved or dispersed in an aqueous medium to form an electrodeposition bath.

**14.** A method according to claim 13 in which the electrodeposition bath in step b) contains a hydrophilic solvent, optionally a hydrophobic solvent; and an organic or inorganic acid.

**15.** A method according to claim 13 or 14 in which the electrodeposition bath contains 0.2 to 5% by weight of the compound of formula I.

**16.** A method according to any of the preceding claims in which the irradiation of the dried, photosensitive layer, in a predetermined pattern, is achieved by exposure of the layer through an image-bearing transparency (mask) comprising some substantially opaque areas and some areas which are substantially transparent to the radiation used; or the radiation is effected by a computer-controlled laser beam.

**17.** A method according to claim 16 in which electromagnetic radiation having a wavelength ranging from 200 to 600 nm is used.

**18.** A method according to claim 16 or 17 in which the radiation source is a mercury vapour arc or a metal halide lamp.

**19.** A substrate bearing a positive image when produced by a method claimed in any of the preceding claims.

**20.** A substrate according to claim 18 in which the substrate is a printed circuit.

European Patent Office

# EUROPEAN SEARCH REPORT

Application Number

EP 92 30 0458

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 265 387 (CIBA-GEIGY) * column 4, lines 10-17; column 5, lines 25-32; column 10, example 1 * | 1-20 | G 03 F 7/16<br>C 09 D 5/44 |
| A | PATENT ABSTRACTS OF JAPAN vol. 12, no. 202 (C-503)(3049), 10 June 1988; & JP - A - 636070 (KANSAI PAINT CO) 12.01.1988 | 1,6-8 | |
| A,D | EP-A-0 315 165 (KANSAI PAINT CO) * claims; page 14, example 1 * | 1-20 | |

TECHNICAL FIELDS SEARCHED (Int. Cl.5)

G 03 F
C 09 D

The present search report has been drawn up for all claims

| Place of search | Date of completion of the search | Examiner |
|---|---|---|
| BERLIN | 05-05-1992 | STOCK H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)